# EUROPÄISCHE PATENTSCHRIFT

(11) **EP 4 072 016 B1**
(45) Veröffentlichungstag und Bekanntmachung des Hinweises auf die Patenterteilung: **28.01.2026**
(21) Anmeldenummer: 22167082.1
(22) Anmeldetag: 07.04.2022
(51) Int. Cl.: H03K 17/96, E05B 81/76

(54) **SENSOREINRICHTUNG FÜR EIN KRAFTFAHRZEUG**
SENSOR DEVICE FOR A MOTOR VEHICLE
DISPOSITIF DÉTECTEUR POUR UN VÉHICULE AUTOMOBILE

(30) Priorität: 09.04.2021 DE 102021108852
(43) Veröffentlichungstag der Anmeldung: 12.10.2022
(73) Patentinhaber: Marquardt GmbH, 78604 Rietheim-Weilheim (DE)
(72) Erfinder: Doster, David, 78667 Villingendorf (DE); Hallah, Kaci, 78532 Tuttlingen (DE); Boos, Nadja, 78658 Zimmern ob Rottweil (DE)
(74) Vertreter: Staeger & Sperling Partnerschaftsgesellschaft mbB

(56) Entgegenhaltungen:
- EP-A1- 2 332 788
- WO-A1-2018/177580
- DE-A1- 102017 100 364
- US-A1- 2019 376 325

## Beschreibung

Die Erfindung betrifft eine Sensoreinrichtung für ein Kraftfahrzeug mit einer Sensorelektrode eines kapazitiven Sensors und einer Nahfeld-Übertragungsspule einer induktiven Nahfeld-Übertragungseinrichtung, einen Türgriff mit einer solchen Sensoreinrichtung sowie ein Kraftfahrzeug mit einem Türgriff oder einer solchen Sensoreinrichtung.

Sensoreinrichtungen mit integrierten kapazitiven Sensoren sind allgemein bekannt. Weiter ist auch deren Verwendung in Türgriffen und insbesondere Türaußengriffen von Kraftfahrzeugen bekannt, beispielsweise durch die Offenlegungsschrift DE 196 17 038 A1. Dabei dient der kapazitive Sensor dazu, eine Annäherung eines potentiellen Bedieners zu erfassen.

Der kapazitive Sensor umfasst dabei eine Sensorelektrode und eine Ansteuer- und Auswerteschaltung. Bei der Annäherung beispielsweise einer Hand des Bedieners wird die Kapazität der Sensorelektrode verändert, wobei diese Kapazitätsänderung durch die Ansteuer- und Auswerteschaltung erfasst und ausgewertet und mithin eine Annäherung erkannt wird.

Wird eine Annäherung erkannt, kann ein Aktor des Fahrzeugs geschalten, das Fahrzeug entriegelt oder eine Vorrichtung zur Fahrzeugentriegelung aktiviert werden, welche beispielsweise abhängig von einer weiteren Legitimierung bzw. einer weiteren Identifikation das Fahrzeug entriegeln kann.

Zur weiteren Identifikation kommen verschiedene Keyless-go-Systeme in Frage. Da Benutzer eines Kraftfahrzeugs meist möglichst wenige zusätzliche Geräte, wie einen Fahrzeugschlüssel, mitführen möchten, liegt es nahe, eine Identifikation durch ohnehin mitgeführte Geräte, wie ein Mobiltelefon, zu ermöglichen.

Zur Identifikation und Legitimationsprüfung des Benutzers kann daher eine Nahfeld-Übertragungseinrichtung vorgesehen sein, welche im Nahbereich die Kommunikation zwischen dem Fahrzeug und beispielsweise dem Mobiltelefon ermöglicht. Eine solche Nahfeld-Übertragungseinrichtung kann beispielsweise auf dem internationalen Near Field Communication (NFC) Übertragungsstandard basieren.

Ein Fahrzeugtürgriff mit sowohl einem kapazitiven Sensor als auch einer Nahfeld-Übertragungseinrichtung wird beispielsweise durch die WO 2014/146949 A1 beschrieben. Dort sind auf einer Leiterplatte eine Übertragungsspule einer Nahfeld-Übertragungseinrichtung und eine kapazitive Sensorelektrode des kapazitiven Sensors nebeneinander bzw. unabhängig voneinander angeordnet.

Problematisch dabei ist, dass der Bauraum in einem Türgriff begrenzt ist bzw. eine Sensoreinrichtung zur Reduzierung des notwendigen Bauraums platzsparend ausgebildet sein soll, was jedoch sowohl dem Funktionsprinzip eines kapazitiven Sensors als auch dem einer Nahfeld-Übertragungseinrichtung entgegenläuft, da diese umso empfindlicher ausgebildet werden können, je größer und entsprechend bauraumintensiver die jeweiligen Sensorelemente (Sensorelektrode und Nahfeld-Übertragungsspule) ausgebildet sind.

Entsprechend ist die von der WO 2014/146949 A1 vorgeschlagene Sensoreinrichtung vergleichsweise groß bzw. bauraumintensiv, da die Sensorelemente nebeneinander angeordnet sind.

Zur Lösung dieses Problems schlägt die DE 10 2018 103 047 A1 vor, die Sensorelektrode innerhalb der Nahfeld-Übertragungsspule anzuordnen, so dass also ein geringerer Platzbedarf bei zugleich großflächiger Ausbildung der Sensorelemente notwendig ist, da diese nicht mehr nebeneinander, sondern ineinander angeordnet sind.

Hierbei ist jedoch nachteilig, dass durch die Platzierung der Sensorelektrode innerhalb der als Antenne dienenden Nahfeld-Übertragungsspule die Feldstärke der Nahfeld-Übertragungsspule reduziert wird, da das elektrische Feld der Nahfeld-Übertragungsspule in die Sensorelektrode einkoppelt und dadurch eine der Feldstärke der Nahfeld-Übertragungsspule entgegenwirkende und diese dadurch reduzierende Gegeninduktivität erzeugt wird.

Weitere Sensoreinrichtungen und Aspekte solcher Sensoreinrichtungen sind zudem aus den Schriften EP 2 332 788 A1, WO 2018/177580 A1 und US 2019/376325 A1 bekannt. Weiter ist auch aus der Schrift DE 10 2017 100364 A1 eine Sensoreinrichtung mit einer Vielzahl von Sensorabschnitten bekannt, welche geradlinig verlaufen.

Der Erfindung liegt deshalb die Aufgabe zugrunde, die vorgenannten Nachteile zu überwinden und eine Sensoreinrichtung mit einer Sensorelektrode eines kapazitiven Sensors und einer Nahfeld-Übertragungsspule einer induktiven Nahfeld-Übertragungseinrichtung bereitzustellen, welche platzsparend ausgebildet ist und bei welcher sich der kapazitive Sensor und die Nahfeld-Übertragungseinrichtung möglichst wenig stören bzw. gegenseitig beeinflussen.

Diese Aufgabe wird durch die Merkmalskombination gemäß Patentanspruch 1 gelöst.

Erfindungsgemäß wird daher eine Sensoreinrichtung für ein Kraftfahrzeug vorgeschlagen. Die Sensoreinrichtung weist ein Substrat auf, auf welchem flächig bzw. flach eine Sensorelektrode zumindest eines kapazitiven Sensors sowie eine Nahfeld-Übertragungsspule mit zumindest einer Windung zumindest einer induktiven Nahfeld-Übertragungseinrichtung angeordnet sind. Die Sensorelektrode wird zumindest abschnittsweise von der Nahfeld-Übertragungsspule umlaufen. Als zumindest abschnittsweise umlaufen wird vorliegend verstanden, dass sich die Nahfeld-Übertragungsspule über zumindest zwei, vorzugsweise drei und weiter vorzugsweise vier Seiten der Sensorelektrode auf dem Substrat erstreckt. Dabei ist erfindungsgemäß vorgesehen, dass die Sensorelektrode eine Vielzahl von geradlinig verlaufenden und miteinander verbundenen Sensorabschnitten aufweist und durch diese gebildet wird. Die Sensorabschnitte der Vielzahl von Sensorabschnitten sind in Reihe und unmittelbar miteinander verbunden, so dass jeweils ein erster Sensorabschnitt unmittelbar in einen direkt nachfolgenden zweiten Sensorabschnitt übergeht. Der jeweils erste Sensorabschnitt und der jeweils zweite Sensorabschnitt schließen dabei einen Winkel zwischen sich ein. Der erste Sensorabschnitt und der zweite Sensorabschnitt sind also nicht parallel oder entlang einer gemeinsamen Achse ausgebildet und entsprechend schräg zueinander.

Durch den erfindungsgemäß vorgeschlagenen Aufbau der Sensoreinrichtung ist die durch die Sensorelektrode gebildete Sensorfläche des kapazitiven Sensors platzsparend an bzw. innerhalb der Nahfeld-Übertragungsspule der induktiven Nahfeld-Übertragungseinrichtung angeordnet, so dass die Sensoreinrichtung äußerst bauraumsparend ausgebildet werden kann, wobei durch den vorgeschlagenen Aufbau der Sensorelektrode bzw. durch die vorgeschlagene Anordnung der Sensorabschnitte der Sensorelektrode erreicht wird, dass in diese durch die Nahfeld-Übertragungsspule keine oder nur eine sehr geringe Gegeninduktivität erzeugt wird, welche entsprechend die Feldstärke der Nahfeld-Übertragungsspule nicht oder nur geringfügig reduziert.

Erfindungsgemäß ist durch den vorgeschlagenen Aufbau der Sensorelektrode bzw. durch die vorgeschlagene Anordnung der Sensorabschnitte der Sensorelektrode vorgesehen, dass die Sensorabschnitte soweit möglich nicht parallel zu der Nahfeld-Übertragungsspule bzw. zu wesentlichen Abschnitten (Spulenabschnitten) der Nahfeld-Übertragungsspule verlaufen. Die wesentlichen Abschnitte sind dabei vorzugsweise längsseitige Spulenabschnitte, welche von zumindest einem stirnseitigen Spulenabschnitt verbunden werden, wobei die längsseitigen Spulenabschnitte länger sind als die stirnseitigen Spulenabschnitte.

Neben dem sich dadurch ergebenden platz- bzw. bauraumminimierenden Aufbau, bei zugleich keiner oder nur geringer Störung des elektrischen Feldes der Nahfeld-Übertragungsspule durch Gegeninduktion in der Sensorelektrode, kommt als weiterer Vorteil der erfindungsgemäßen Sensoreinrichtung hinzu, dass für den Benutzer lediglich ein Bereich der Sensoreinrichtung relevant ist, in welchem sowohl die Nahfeld-Übertragungsspule als auch die Sensorelektrode angeordnet ist, so dass sich der Benutzer nicht merken muss, in welchem Bereich die Hand und in welchem Bereich ein Identifikator (z.B. Mobiltelefon) an die Sensoreinrichtung angenähert werden muss. Soweit technisch nicht vermeidbar, sollte ein Leiter bzw. eine Leiterbahn aus welchem die Sensorelektrode gebildet ist bzw. die Sensorabschnitte nur sehr geringe oder vorzugsweise keine parallel zu der Nahfeld-Übertragungsspule bzw. zu den Spulenabschnitten verlaufenden Anteile aufweisen. Sind parallel verlaufende Anteile technisch nicht vermeidbar, sollten diese möglichst kurz sein und sich nicht über die gesamte Länge der Nahfeld-Übertragungsspule erstrecken. Vorteilhaft ist beispielsweise, wenn solche parallelen Anteile maximal 1/5 und weiter vorzugsweise maximal 1/10 der Länge der Nahfeld-Übertragungsspule oder der Spulenabschnitte lang sind. Weiter sollten solche parallelen Anteile zur Reduktion der Induktion mit einem maximal möglichen Abstand von der Nahfeld-Übertragungsspule bzw. den Spulenabschnitten und mithin in einer Mitte bzw. an oder entlang einer Mittellinie der Nahfeld-Übertragungsspule angeordnet sein.

Weiter können die Sensorabschnitte der Vielzahl von Sensorabschnitte gleich oder unterschiedlich lang sein, wobei die Winkel zwischen den Sensorabschnitten ebenfalls gleich oder unterschiedlich sein können.

Eine vorteilhafte Weiterbildung der Sensoreinrichtung sieht zudem vor, dass die Nahfeld-Übertragungsspule zumindest einen im Wesentlichen geradlinigen Spulenabschnitt aufweist, wobei die Sensorabschnitte in einer gedachten Verlängerung den zumindest einen Spulenabschnitt oder eine gedachte Verlängerung des zumindest einen Spulenabschnitts schneiden. Wie bereits beschrieben kann die Nahfeld-Übertragungsspule als Spulenabschnitte längsseitige und stirnseitige Spulenabschnitte aufweisen, wobei die Sensorabschnitte in ihrer gedachten Verlängerung vorzugsweise die längsseitigen Spulenabschnitte bzw. deren gedachte Verlängerung schneiden.

Vorteilhaft kann hierbei ferner vorgesehen sein, dass die Nahfeld-Übertragungsspule miteinander verbundene und zueinander im Wesentlichen rechtwinklige Spulenabschnitte aufweist oder durch diese gebildet ist, welche gemeinsam einen im Wesentlichen rechteckigen Bereich des Substrats abgrenzen, innerhalb welchem vorzugsweise die Sensorelektrode angeordnet ist.

Zur Bauraumreduzierung und Platzersparnis ist eine Weiterbildung vorteilhaft, bei welcher die Sensorelektrode vollständig in einem von der Nahfeld-Übertragungsspule abgegrenzten Bereich des Substrats angeordnet ist, bei welchem es sich um den genannten rechteckigen Bereich handeln kann.

Vorzugsweise ist das Substrat eine starre oder flexible Leiterplatte.

Weiter ist von Vorteil, wenn die Sensorelektrode und/oder die Nahfeld-Übertragungsspule zumindest abschnittsweise und insbesondere vollständig durch auf dem Substrat ausgebildete Leiterbahnen gebildet werden/wird, so dass also die Sensorelektrode und/oder die Nahfeld-Übertragungsspule als Leiterbahnstruktur bezeichnet werden kann.

Gemäß einer weiteren vorteilhaften Variante weist die Sensoreinrichtung ferner eine Steuerelektronik auf, welche signaltechnisch mit der Sensorelektrode und/oder mit der Nahfeld-Übertragungsspule verbunden ist. Die Sensorelektrode und/oder die Nahfeld-Übertragungsspule können unmittelbar oder beispielsweise über eine Anschlussleitung, welche ebenfalls als Leiterbahn ausgebildet sein kann, mit der Steuerelektronik signaltechnisch verbunden sein. Vorzugsweise wird durch die Steuerelektronik eine Ansteuer- und Auswerteschaltung zur Ansteuerung und Auswertung der Sensorelektrode und/oder der Nahfeld-Übertragungsspule implementiert, so dass die Sensorelektrode mit der Steuerelektronik den kapazitiven Sensor und/oder die Nahfeld-Übertragungsspule mit der Steuerelektronik die induktiven Nahfeld-Übertragungseinrichtung bilden/bildet.

Die Steuerelektronik kann auf dem Substrat angeordnet sein. Dabei kann die Steuerelektronik auf einer Seite bzw. Fläche des Substrats angeordnet sein, auf welcher auch die Sensorelektrode und/oder die Nahfeld-Übertragungsspule angeordnet sind/ist. Alternativ kann die Steuerelektronik auch auf einer gegenüberliegenden Seite bzw. Fläche des Substrats angeordnet sein, wobei diese dann über eine Kante des Substrats oder durch das Substrat hindurch signaltechnisch mit der Sensorelektrode und/oder der Nahfeld-Übertragungsspule verbunden sein kann.

Ein weiterer Aspekt der Erfindung betrifft einen Türgriff für ein Kraftfahrzeug mit einer erfindungsgemäßen Sensoreinrichtung.

Ferner betrifft ein Aspekt der Erfindung ein Kraftfahrzeug mit einer erfindungsgemäßen Sensoreinrichtung und/oder einem erfindungsgemäßen Türgriff.

Die vorstehend offenbarten Merkmale sind beliebig kombinierbar, soweit dies technisch möglich ist und diese nicht im Widerspruch zueinander stehen.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:
- Fig. 1: eine Sensoreinrichtung;
- Fig. 2: eine Sensoreinrichtung mit Steuerelektronik.

Die Figuren sind beispielhaft schematisch. Gleiche Bezugszeichen in den Figuren weisen auf gleiche funktionale und/oder strukturelle Merkmale hin.

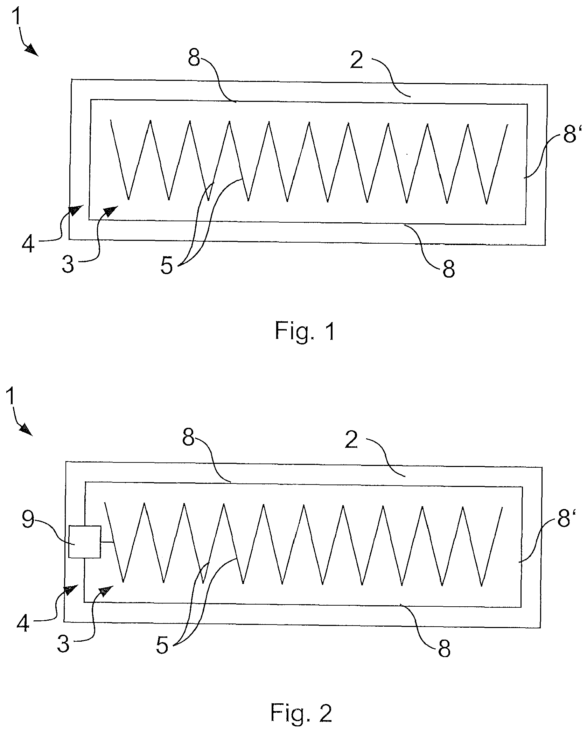

Figur 1 zeigt eine Sensoreinrichtung 1, welche ein Substrat 2 umfasst, auf welchem flächig eine Sensorelektrode 3 zumindest eines kapazitiven Sensors sowie eine Nahfeld-Übertragungsspule 4 mit zumindest einer Windung zumindest einer induktiven Nahfeld-Übertragungseinrichtung angeordnet sind.

Bei dem Substrat 2 handelt es sich vorliegend um eine Leiterplatte, wobei die Sensorelektrode 3 und die Nahfeld-Übertragungsspule 4 auf der Leiterplatte ausgebildete und beispielsweise geätzte oder gedruckte Leiterbahnen sind.

Um einen platzsparenden Aufbau der Sensoreinrichtung 1 zu ermöglichen, ist die Sensorelektrode 3 bzw. die Sensorabschnitte 5, welche die Sensorelektrode 3 bilden, vollständig innerhalb der Nahfeld-Übertragungsspule 4 bzw. innerhalb eines von der Nahfeld-Übertragungsspule 4 abgegrenzten Bereichs angeordnet.

Die Nahfeld-Übertragungsspule 4 wird dabei von den zwei einander gegenüberliegenden längsseitigen Spulenabschnitten 8 und zwei weiteren stirnseitigen Spulenabschnitten 8' gebildet, wobei die stirnseitigen Spulenabschnitte 8' kürzer sind als die längsseitigen Spulenabschnitte 8, so dass die Spule bzw. das durch die Spule induzierte elektrische Feld im Wesentlichen durch die längsseitigen Spulenabschnitte 8 bestimmt wird.

Um zugleich eine Einkopplung des von der Nahfeld-Übertragungsspule 4 erzeugten elektromagnetischen Feldes in die Sensorelektrode 3 zu minimieren, so dass es auch lediglich zu einer minimalen Gegeninduktion und einer damit verbundenen minimierten Schwächung des elektromagnetischen Feldes kommt, sind die Sensorabschnitte 5 schräg zu den längsseitigen Spulenabschnitten 8 und zu den stirnseitigen Spulenabschnitte 8' der Nahfeld-Übertragungsspule 4 bzw. diese in einer gedachten Verlängerung schneidend angeordnet.

Jeweils zwei unmittelbar aufeinanderfolgende Sensorabschnitte 5 der Vielzahl von Sensorabschnitten 5 schließen dabei einen Winkel zwischen sich ein, wobei die Winkel zwischen den Sensorabschnitten 5 gleich oder unterschiedlich sein können.

Wie deutlich erkennbar, sind alle Sensorabschnitte 5 schräg gegenüber allen Spulenabschnitten 8, 8' der die Sensorelektrode 3 vollständig umlaufenden bzw. umschließenden Nahfeld-Übertragungsspule 4 ausgerichtet,

Figur 2 zeigt eine Sensoreinrichtung gemäß Figur 1, wobei ferner eine Steuerelektronik 9 auf dem Substrat 2 angeordnet ist, mit welcher sowohl die Sensorelektrode 3 als auch die Nahfeld-Übertragungsspule 4 verbunden ist.

## Patentansprüche

1. Sensoreinrichtung (1) für ein Kraftfahrzeug,
aufweisend ein Substrat (2), auf welchem flächig eine Sensorelektrode (3) zumindest eines kapazitiven Sensors sowie eine Nahfeld-Übertragungsspule (4) mit zumindest einer Windung zumindest einer induktiven Nahfeld-Übertragungseinrichtung angeordnet sind,
wobei die Sensorelektrode (3) zumindest abschnittsweise von der Nahfeld-Übertragungsspule (4) umlaufen wird,
wobei die Sensorelektrode (3) durch eine Vielzahl von geradlinig verlaufenden und miteinander verbundenen Sensorabschnitten (5) gebildet ist,
**dadurch gekennzeichnet, dass** die Sensorabschnitte (5) der Vielzahl von Sensorabschnitten (5) in Reihe und unmittelbar miteinander verbunden sind, so dass jeweils ein erster Sensorabschnitt unmittelbar in einen direkt nachfolgenden zweiten Sensorabschnitt übergeht,
wobei der erste Sensorabschnitt und der zweite Sensorabschnitt einen Winkel zwischen sich einschließen und
wobei die Sensorabschnitte nicht parallel zu der Nahfeld-Übertragungsspule verlaufen.

2. Sensoreinrichtung nach Anspruch 1,
wobei die Nahfeld-Übertragungsspule (4) zumindest einen im Wesentlichen geradlinigen Spulenabschnitt (8, 8') aufweist,
und wobei die Sensorabschnitte (5) in einer gedachten Verlängerung den zumindest einen Spulenabschnitt (8, 8') oder eine gedachte Verlängerung des zumindest einen Spulenabschnitts (8, 8') schneiden.

3. Sensoreinrichtung nach Anspruch 2,
wobei die Nahfeld-Übertragungsspule (4) miteinander verbundene und zueinander im Wesentlichen rechtwinklige Spulenabschnitte (8, 8') aufweist, welche gemeinsam einen im Wesentlichen rechteckigen Bereich des Substrats (2) abgrenzen.

4. Sensoreinrichtung nach einem der vorhergehenden Ansprüche,
wobei die Sensorelektrode (3) vollständig in einem von der Nahfeld-Übertragungsspule (4) abgegrenzten Bereich des Substrats (2) angeordnet ist.

5. Sensoreinrichtung nach einem der vorhergehenden Ansprüche,
wobei das Substrat (2) eine starre oder flexible Leiterplatte ist.

6. Sensoreinrichtung nach einem der vorhergehenden Ansprüche,
wobei die Sensorelektrode (3) und/oder die Nahfeld-Übertragungsspule (4) zumindest abschnittsweise durch auf dem Substrat (2) ausgebildete Leiterbahnen gebildet werden/wird.

7. Sensoreinrichtung nach einem der vorhergehenden Ansprüche,
wobei die Sensorelektrode (3) und/oder die Nahfeld-Übertragungsspule (4) vollständig durch auf dem Substrat (2) ausgebildete Leiterbahnen gebildet werden/wird.

8. Sensoreinrichtung nach einem der vorhergehenden Ansprüche,
ferner aufweisend eine Steuerelektronik (9), welche signaltechnisch mit der Sensorelektrode (3) und/oder mit der Nahfeld-Übertragungsspule (4) verbunden ist.

9. Türgriff für ein Kraftfahrzeug mit einer Sensoreinrichtung (1) gemäß einem der vorhergehenden Ansprüche.

10. Kraftfahrzeug mit einer Sensoreinrichtung (1) gemäß einem der vorhergehenden Ansprüche 1 bis 8 und/oder einem Türgriff gemäß dem vorhergehenden Anspruch.

## Claims

1. A sensor device (1) for a motor vehicle,
having a substrate (2), on which a sensor electrode (3) of at least one capacitive sensor and a near-field transmission coil (4) with at least one turn of at least one inductive near-field transmission device are arranged in a planar manner,
wherein the sensor electrode (3) is at least partially surrounded by the near-field transmission coil (4),
wherein the sensor electrode (3) is formed by a plurality of sensor sections (5) extending linearly and connected to one another,
**characterised in that**
the sensor sections (5) of the plurality of sensor sections (5) are connected in series and directly to one another, so that a respective first sensor section directly transitions into a directly subsequent second sensor section,
wherein the first sensor section and the second sensor section enclose an angle between them, and
wherein the sensor sections do not extend in parallel to the near-field transmission coil.

2. The sensor device according to claim 1,
wherein the near-field transmission coil (4) has at least one substantially linear coil section (8, 8'),
and wherein, in an imaginary extension, the sensor sections (5) intersect with the at least one coil section (8, 8') or an imaginary extension of the at least one coil section (8, 8').

3. The sensor device according to claim 2,
wherein the near-field transmission coil (4) has coil sections (8, 8') connected and substantially at right angles to one another, which together delimit a substantially rectangular area of the substrate (2).

4. The sensor device according to any one of the preceding claims,
wherein the sensor electrode (3) is completely arranged in an area of the substrate (2) delimited from the near-field transmission coil (4).

5. The sensor device according to any one of the preceding claims,
wherein the substrate (2) is a rigid or flexible printed circuit board.

6. The sensor device according to any one of the preceding claims,
wherein the sensor electrode (3) and/or the near-field transmission coil (4) is/are at least partially formed by conductive traces established on the substrate (2).

7. The sensor device according to any one of the preceding claims,
wherein the sensor electrode (3) and/or the near-field transmission coil (4) are completely formed by conductive traces established on the substrate (2).

8. The sensor device according to any one of the preceding claims,
further having control electronics (9), which are signally connected to the sensor electrode (3) and/or to the near-field transmission coil (4).

9. A door handle for a motor vehicle, having a sensor device (1) according to any one of the preceding claims.

10. A motor vehicle, having a sensor device (1) according to any one of the preceding claims 1 to 8 and/or a door handle according to the preceding claim.

## Revendications

1. Dispositif de capteur (1) pour véhicule automobile,
présentant un substrat (2), sur lequel sont agencés sur une surface une électrode de capteur (3) d'au moins un capteur capacitif ainsi qu'une bobine de transmission en champ proche (4) avec au moins une spire d'au moins un dispositif de transmission inductive en champ proche,
dans lequel l'électrode de capteur (3) est entourée au moins par sections par la bobine de transmission en champ proche (4),
dans lequel l'électrode de capteur (3) est formée par une pluralité de sections de capteur (5) s'étendant en ligne droite et reliées entre elles,
**caractérisé en ce que**
les sections de capteur (5) de la pluralité de sections de capteur (5) sont reliées entre elles en série et immédiatement, de sorte qu'une première section de capteur passe immédiatement dans une deuxième section de capteur directement suivante,
dans lequel la première section de capteur et la deuxième section de capteur incluent un angle entre elles et
dans lequel les sections de capteur ne s'étendent pas parallèlement à la bobine de transmission en champ proche.

2. Dispositif de capteur selon la revendication 1,
dans lequel la bobine de transmission en champ proche (4) présente au moins une section de bobine essentiellement droite (8, 8'),
et dans lequel les sections de capteur (5), dans un prolongement imaginaire, coupent l'au moins une section de bobine (8, 8') ou un prolongement imaginaire de l'au moins une section de bobine (8, 8').

3. Dispositif de capteur selon la revendication 2,
dans lequel la bobine de transmission en champ proche (4) présente des sections de bobine (8, 8') reliées entre elles et essentiellement perpendiculaires l'une par rapport à l'autre, lesquelles délimitent ensemble une zone essentiellement rectangulaire du substrat (2).

4. Dispositif de capteur selon l'une quelconque des revendications précédentes, dans lequel l'électrode de capteur (3) est complètement agencée dans une zone du substrat (2) délimitée par la bobine de transmission en champ proche (4).

5. Dispositif de capteur selon l'une quelconque des revendications précédentes, dans lequel le substrat (2) est une carte de circuit imprimé rigide ou flexible.

6. Dispositif de capteur selon l'une quelconque des revendications précédentes, dans lequel l'électrode de capteur (3) et/ou la bobine de transmission en champ proche (4) sont formées au moins par sections par des pistes conductrices formées sur le substrat (2).

7. Dispositif de capteur selon l'une quelconque des revendications précédentes, dans lequel l'électrode de capteur (3) et/ou la bobine de transmission en champ proche (4) sont entièrement formées par des pistes conductrices formées sur le substrat (2).

8. Dispositif de capteur selon l'une quelconque des revendications précédentes, comprenant en outre une électronique de commande (9), laquelle est reliée pour les signaux à l'électrode de capteur (3) et/ou à la bobine de transmission en champ proche (4).

9. Poignée de porte pour un véhicule automobile avec un dispositif de capteur (1) selon l'une quelconque des revendications précédentes.

10. Véhicule automobile avec un dispositif de capteur (1) selon l'une quelconque des revendications 1 à 8 et/ou une poignée de porte selon la revendication précédente.
